Europäisches Patentamt

European Patent Office

Office européen des brevets

(19)

(11)  **EP 0 446 438 B1**

(12)  **EUROPÄISCHE PATENTSCHRIFT**

(45) Veröffentlichungstag und Bekanntmachung des Hinweises auf die Patenterteilung:
   **01.05.1996   Patentblatt 1996/18**

(51) Int Cl.⁶: **H01L 29/06**, H01L 29/04, H01L 29/74, H01L 29/861, H01L 21/3063

(21) Anmeldenummer: **90123238.9**

(22) Anmeldetag: **04.12.1990**

(54) **Verfahren zur definierten Spannungseinstellung bei überkopfzündfesten Halbleiterbauelementen und Halbleiterbauelemente mit definierter Überkopfzündspannung**

Method of setting the voltage in a well-defined manner in semiconductor devices which withstand voltage-breakover firing and semiconductor devices having a well-defined breakover voltage

Méthode pour régler la tension d'une manière bien définie dans des dispositifs semi-conducteurs supportant les amorçages par retournement et dispositifs semi-conducteurs à tension de retournement bien définie

(84) Benannte Vertragsstaaten:
   **CH DE GB LI SE**

(30) Priorität: **12.03.1990  DE 4007816**

(43) Veröffentlichungstag der Anmeldung:
   **18.09.1991   Patentblatt 1991/38**

(73) Patentinhaber: **SIEMENS AKTIENGESELLSCHAFT
   D-80333 München (DE)**

(72) Erfinder:
   • **Kuhnert, Reinhold, Dr.
   W-8000 München 19 (DE)**
   • **Schwarzbauer, Herbert, Dr.
   W-8000 München 70 (DE)**
   • **Türkes, Peter, Dr.
   W-8025 Unterhaching (DE)**

(56) Entgegenhaltungen:
   **EP-A- 0 317 915        EP-A- 0 446 439**

   • **JOURNAL OF VACUUM SCIENCE AND TECHNOLOGY: PART B. Bd. 3, Nr. 4, Juli 1985, NEW YORK US, Seiten 1015-1024; G. KAMINSKY : 'Micromachining of silicon mechanical structures'**
   • **PATENT ABSTRACTS OF JAPAN, vol. 9, no. 27 (E-294)(1750) 6. Februar 1985 ; & JP-A-59 172 772**
   • **IEEE TRANSACTIONS ON ELECTRON DEVICES, Bd. ED-30, Nr. 7, Juli 1983, NEW YORK US, Seiten 816-824 ; V.A.K. TEMPLE: 'Controlled turn-on thyristors'**
   • **SPEKTRUM DER WISSENSCHAFT, Juni 1983, Seiten 38-50**

EP 0 446 438 B1

## Beschreibung

Die Erfindung bezieht sich auf ein Verfahren nach dem Oberbegriff des Patentanspruchs 1 und ein Halbleiterbauelement nach dem Oberbegriff des Patentanspruchs 6.

Aus den Konferenzunterlagen zur "IEEE International Conference Thyristors and Variable and Static Equipment for AC and DC Transmission", 30.11.1981 bis 03.12.1981 in London, aus der darin enthaltenen Veröffentlichung von V. A. K. Temple (GE) zum Thema "Advanced Light Triggered Thyristors For Electric Power Systems", insbesondere Seite 88 und Seite 91, Figur 10 ist ein Verfahren und eine Thyristorstruktur dieser Art bekannt. Bei dem von V. A. K. Temple erwähnten Verfahren werden ohne spezielle Berücksichtigung der Vertiefungsgeometrie, mehrere Vertiefungen in das vollständig dotierte Halbleiterbauelement geätzt, dadurch ergeben sich aufgrund der dabei schlecht zu beherrschenden Verfahrensparameter nicht definiert reproduzierbare Überkopfspannungen.

Aus den Patent Abstracts of Japan, Vol. 9, Nr. 27 (E-294) (1750) 6. Februar 1985 und der japanischen Patentanmeldung mit der Anmeldungsnummer 59 172 772 ist ein Thyristor bekannt, bei dem zur Erzeugung eines lokal definierten Lawinendurchbruchs eine Vertiefung vorgesehen ist, die durch ebene Flächen begrenzt ist.

Der Erfindung liegt die Aufgabe zugrunde, eine feste Überkopfzündspannung des Halbleiterbauelements so einzustellen, daß eine mittlere Schwankungsbreite aufgrund nicht trivial zu beherrschender Parameter minimal ist. Dies wird erfindungsgemäß bei einem Verfahren der eingangs angedeuteten Art durch eine Ausbildung nach dem kennzeichnenden Teil von Anspruch 1 erreicht.

Die Erfindung zeichnet sich insbesondere durch Einfachheit und durch gute Reproduzierbarkeit einer gewünschten Überkopfzündspannung aus.

Die Patentansprüche 2 bis 5 sind auf bevorzugte Weiterbildungen des erfindungsgemäßen Verfahrens gerichtet.

Die Patentansprüche 6 bis 8 betreffen ein Halbleiterbauelement mit definierter Überkopfzündspannung, das mit Vorteil nach einem der Ansprüche 1 bis 5 herstellbar ist.

Die Erfindung wird nachfolgend anhand der Zeichnung näher erläutert. Dabei zeigt

Figur 1     eine Darstellung der beim Verfahren nach der Erfindung verwendeten Ätzmaskenorientierung relativ zur Orientierung der Kristallgitterebenen (Verwendung von Miller-Indizes),

Figur 2     Vertiefungen und Dotierungsverläufe bei Anwendung des erfindungsgemäßen Verfahrens,

Figur 3     einen Aufbau eines Thyristors mit Vertiefungen nach Figur 2,

Figur 4     einen Aufbau einer Leistungsdiode mit Vertiefungen nach Figur 2 und

Figur 5     die bei den Vertiefungen (Mulden) nach Figur 2 erreichbare Überkopfzündspannung $U_{BO}$ (break over voltage), bei fester Dotierungstiefe $x_{pn}$, in Abhängigkeit von der Muldentiefe h und der Muldenform P (Pyramide) bzw. PS (Pyramidenstumpf).

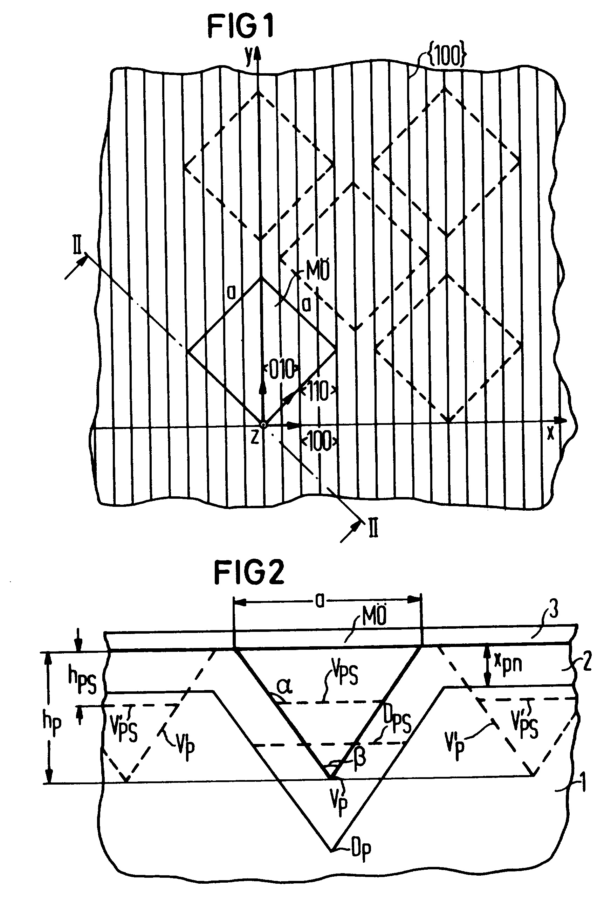

Figur 1 zeigt in Draufsicht einen Teil der Oberfläche eines Halbleiter Bauelements mit definierter Überkopfzündspannung, in die mit Hilfe einer Ätzmaske Vertiefungen eingeätzt werden. Dabei wird zuerst, in einer bevorzugten Weiterbildung des erfindungsgemäßen Verfahrens, eine Maske mit quadratischer Maskenöffnung MÖ, der Kantenlänge a, so auf ein {100} -Halbleitermaterial aufgebracht, daß eine Kante der Maskenöffnung parallel zur <110> -Richtung im Kristall ist. Gestrichelt angedeutet sind weitere Maskenöffnungen dieser Art.

Nach dem Aufbringen einer Maske mit erfindungsgemäßer Form und Orientierung der Maskenöffnung folgt eine anisotrope Ätzung. Die Ätzung muß anisotrop erfolgen, damit sich die Regularität der Kristallgitterstruktur auf die Vertiefungsgeometrie überträgt. Die meisten solcher anisotroper Ätzlösungen, wirken schnell in Kristallrichtung senkrecht zur (110)-Ebene und langsamer in die Kristallrichtung senkrecht zur (100)-Ebene. In Richtung senkrecht zur (111)-Ebene wird der Kristall von anisotropen Ätzmitteln nicht (oder nur sehr langsam) abgebaut. Das Ätzverfahren selbst ist aus dem Artikel von Angell, Terry und Barth "Mikromechanik aus Silicium", in der Zeitschrift Spektrum der Wissenschaft, Juni 1983, insbesondere Seite 41 bekannt.

Die Figur 2 stellt einen Schnitt entlang der in Figur 1 gezeigten II-II-Linie dar, die gezeigte pyramidenstumpf- bzw. pyramidenförmige Vertiefung $V_{PS}$ bzw. $V_p$, entsteht nun bei Verwendung einer Ätzmaske 3 mit quadratischer Öffnung MÖ der Kantenlänge a und einer <110> -Öffnungsorientierung bezüglich des {100} -Materials 1 und 2. Die der Form der Vertiefungen folgenden Dotierungsgrenzflächen $D_{PS}$ bzw. $D_P$ trennen das vertiefungsseitig dotierte und $x_{pn}$ dicke Gebiet 2 von dem dazu unterschiedlich dotierten Grundmaterial 1. Der Winkel $\alpha$ tritt nur im Fall einer pyramidenstumpfförmigen Vertiefung $V_{PS}$ in Erscheinung und wird von jeweils einer der vier {111} -Kristallebenen und der Bodenfläche der pyramidenstumpfförmigen Vertiefung eingeschlossen, der Winkel $\beta$ stellt den Spitzenwinkel der Pyramide dar und wird durch jeweils zwei der vier {111} -Kristallebenen eingeschlossen.

Die Winkel betragen ungefähr:
$$\alpha = 90° + \text{arctg}\,(\sqrt{2}/2) = 125°$$

$$\beta = 2^* \text{ arctg } (\sqrt{2}/2) = 70°$$

Wie in Figur 1 gestrichelt angedeutet, können mehrere Maskenöffnungen vorgesehen werden, um zum Beispiel höhere Stromwerte zu ermöglichen, dies entspricht dann den in Figur 2 ebenfalls gestrichelt angedeuteten Vertiefungen $V_{P'}$ bzw. $V_{PS'}$.

Wird bei vorgegebener, durch die Ätzdauer bestimmten Ätztiefe $h_{PS}$ bzw. $h_P$, statt einer pyramidenförmigen Vertiefung eine pyramidenstumpfförmige angestrebt, so kann dies durch einfaches Vergrößern der Kantenlänge a der Maskenöffnung MÖ erreicht werden. Nach Ablauf der Ätzdauer wird das Ätzmittel und die Maske entfernt. Erfindungsgemäß wird erst zu diesem Zeitpunkt vertiefungsseitig eine Dotierung vorgenommen, so daß sich eine, je nach Dotierungstiefe ins Grundmaterial verschobene, der Oberflächenkontur folgende Dotierungsgrenzfläche ergibt. Im Fall der in Figur 2 gezeigten Vertiefung $V_P$ bzw. $V_{PS}$ wird eine Dotierungsgrenzfläche $D_P$ bzw. $D_{PS}$ gebildet.

Zur Fertigstellung des Halbleiterbauelements mit fester Überkopfzündspannung folgen weitere Schritte, die aber nicht mehr Gegenstand der Erfindung sind.

Es ist von Vorteil überkopfzündfeste Halbleiterbauelemente mit definierter Überkopfzündspannung, wie zum Beispiel Leistungsdioden und Thyristoren, nach dem erfindungsgemäßen Verfahren herzustellen.

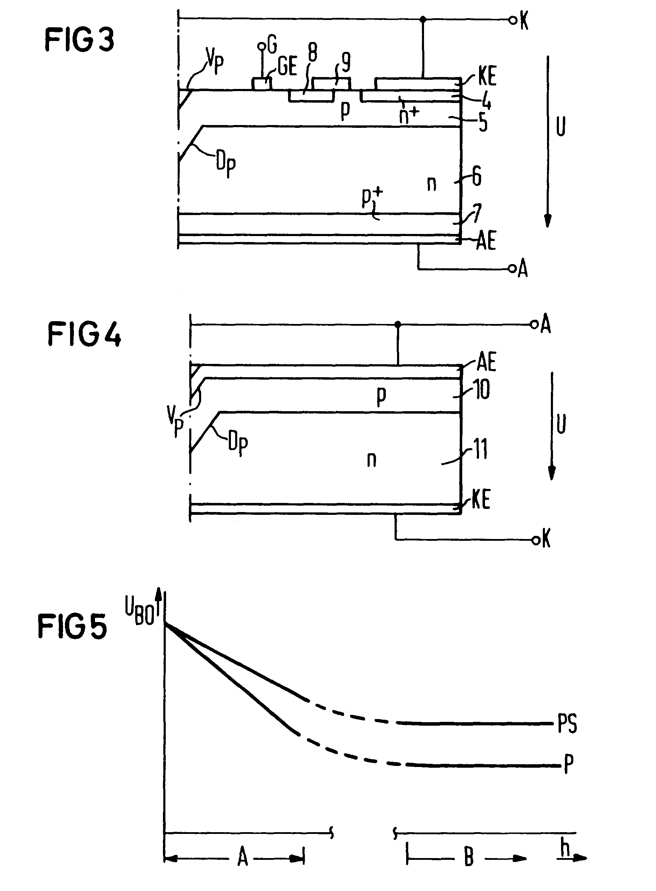

Figur 3 stellt dabei einen überkopfzündfesten Thyristor mit fester Überkopfzündspannung dar, der aus dotiertem Halbleitermaterial besteht. Er weist vier Schichten abwechselnder Dotierung auf. Die erste Schicht, die den Emitter 4 und dem Hilfsemitter 8 bildet, besteht aus $n^+$-dotiertem Material und ist elektrisch leitend mit der Kathodenelektrode KE verbunden. An die Emitter schließt sich eine p-Basisschicht 5 an und an diese wiederum eine n-Basisschicht 6. An die n-Basisschicht 6 grenzt die $p^+$-Emitterschicht 7, die elektrisch leitend mit der Anodenelektrode AE verbunden ist. Weitere metallische Bereiche an der kathodenseitigen Oberfläche des Thyristors sind die Gateelektrode GE, die elektrisch leitend mit der p-Basisschicht 5 verbunden ist und die elektrisch leitende Verbindung 9, die den Hilfsemitters 8 mit der p-Basisschicht 5 verbindet. Die Gateelektrode GE ist mit dem Gateanschluß G verbunden, die Kathodenelektrode KE ist mit der Kathodenanschlußklemme K elektrisch leitend verbunden und gleiches gilt für die Anodenelektrode AE, die mit der Anodenanschlußklemme A verbunden ist. Zwischen den Klemmen K und A liegt eine Spannung U an. Der Thyristor weist in einem zentralen Bereich der Oberfläche eine pyramidenförmige Vertiefung $V_P$ auf und kann mit Hilfe des erfindungsgemäßen Verfahrens besonders vorteilhaft hergestellt werden. Die Dotierungsgrenzfläche $D_P$, welche die p-Basisschicht 5 von der n-Basisschicht 6 trennt, ist somit nicht mehr eben, sondern folgt im Abstand der Dotierungstiefe dem Dotierungsprofil $V_P$. Das Dotierungskonzentrationsgefälle zwischen p-Basisschicht 5 und n-Basisschicht 6 läßt eine Raumladungszone in diesem Bereich entstehen, diese wiederum bewirkt eine elektrische Feldstärke. Die elektrische Feldstärke und damit auch die Überkopfzündspannung sind von der Vertiefungsgeometrie und vom Dotierungsprofil abhängig. Aufgrund der angelegten Spannung U entsteht eine Feldstärke im Bereich der Vertiefung, die zu einem lokalen Lawinendurchbruch und damit zu einem Basisstrom in Richtung Gate und Zündstrukturen 8, 9 führt. Ist keine Zündstruktur 8, 9 vorhanden, so fließt der Basisstrom in Richtung Gate und Emitter 4. Damit ein Zünden des Thyristors infolge des Lawinendurchbruchstromes schnell erfolgt, können mehrere Vertiefungen, wie bereits in Figur 1 und 2 angedeutet, vorgesehen werden.

In Figur 4 wird eine Leistungsdiode mit fester Überkopfzündspannung dargestellt. Die Leistungsdiode besteht aus einer p-dotierten Schicht 10 und einer daran angrenzenden n-dotierten Schicht 11, wobei die p-dotierte Schicht 10 elektrisch leitend mit der Anodenelektrode AE und der Anodenklemme A verbunden ist und die n-dotierte Schicht 11 elektrisch leitend mit der Kathodenelektrode KE und der Kathodenklemme K verbunden ist. Die Vertiefung $V_P$ kann sowohl beim Thyristor als auch bei der Leistungsdiode durch eine Metallisierungsschicht abgedeckt werden; wie aus Figur 4 ersichtlich, besitzt die Metallisierung zur Herstellung der Anodenelektrode keinerlei Aussparungen im Bereich der Vertiefung. Unterhalb der Vertiefung $V_P$ befindet sich, wie in Figur 3 bereits erläutert, eine der Oberflächenkontur folgende Dotierungsgrenzfläche $D_P$. Wird eine genügend hohe Spannung U zwischen den Klemmen A und K angelegt, so kann ein Lawinendurchbruch örtlich, im Bereich der Vertiefung, festgelegt werden. Ist der Ort des Lawinendurchbruchs bekannt, können entsprechende Schutzmaßnahmen gegen thermische Überlastung getroffen werden.

Figur 5 stellt die definierte Einstellung einer Überkopfzündspannung $U_{BO}$ (break over voltage) für die beiden Fälle des Pyramidenstumpfes und der Pyramide dar, wobei die Dotierungstiefe $x_{pn}$ als fest anzusehen ist. Figur 5 zeigt, daß die Überkopfzündspannung bei pyramidenförmiger Vertiefung stets niedriger ist als bei pyramidenstumpfförmiger Vertiefung. Für den Bereich A, also für sehr kleine Werte von h, fällt $U_{BO}$ von einem Maximalwert bei h = 0 in Richtung zu größeren h-Werten ab.

Für den Bereich B, also h sehr viel größer als $x_{pn}$, ist die Überkopfzündspannung weitgehend unabhängig von der Muldentiefe h und hängt nur noch davon ab, ob es sich um eine pyramiden- oder pyramidenstumpfförmige Mulde handelt.

Es gelten folgende Zusammenhänge:

Für den Bereich h kleiner, gleich $x_{pn}$ (Bereich A) wird

$$U_{BO} = f (125°, x_{pn}/h_{PS})$$

für den Pyramidenstumpf

$$U_{BO} = f ( 70°, x_{pn}/h_P)$$

für die Pyramide.

Für den Bereich h sehr viel größer $x_{pn}$ (Bereich B) wird

$U_{BO} = f (125°) = $ const. für den Pyramidenstumpf

$U_{BO} = f ( 70°) = $ const. für die Pyramide.

Dies zeigt, daß bei fester Vorgabe des gut kontrollierbaren Dotierungsprofils mit der Dotierungstiefe $x_{pn}$, die Überkopfzündspannung eines Halbleiterbauelementes definiert reproduzierbar eingestellt werden kann. Im letzteren Fall, also für h sehr viel größer $x_{pn}$, ist die Überkopfzündspannung sogar unabhängig von der Muldentiefe und hängt nur noch von der Art der Vertiefungsform ab.

## Patentansprüche

1. Verfahren zur definierten Spannungseinstellung bei überkopfzündfesten Halbleiterbauelementen, bei dem das Halbleiterbauelement an seiner Oberfläche mit einer Maske abgedeckt wird und eine Vertiefung mittels eines Ätzschrittes unterhalb der Maskenöffnung gebildet wird um einen lokal definierten Lawinendurchbruch zu erzeugen, **dadurch gekennzeichnet,** daß bei gegebenem Halbleiterkristallgitter und anisotroper Ätzung, die Form der Maskenöffnung und deren Orientierung entlang einer Kristallrichtung so gewählt wird, daß die Vertiefung polyederförmig ist, deren Seitenwände von Kristallebenen gebildet werden, und daß erst nach dem Ätzschritt eine Dotierung im Bereich der mit der Vertiefung versehenen Oberfläche erfolgt.

2. Verfahren nach Anspruch 1, **dadurch gekennzeichnet,** daß ein {100} -Wafer verwendet wird.

3. Verfahren nach Anspruch 2, **dadurch gekennzeichnet,** daß eine rechteckige oder quadratische Ätzmaskenöffnung benutzt wird.

4. Verfahren nach Anspruch 3, **dadurch gekennzeichnet,** daß die Ätzmaskenöffnung entlang der <110> -Richtung des {100} -Wafers ausgerichtet ist.

5. Verfahren nach Anspruch 4, **dadurch gekennzeichnet,** daß durch die Wahl der Kantenlänge der Ätzmaskenöffnung und der Ätztiefe entweder eine pyramidenstumpfförmige oder eine pyramidenförmige Vertiefung gezielt erzeugt wird.

6. Halbleiterbauelement mit definierter Überkopfzündspannung, wobei das Halbleiterbauelement eine Vertiefung an seiner Oberfläche aufweist, um einen lokal definierten Lawinendurchbruch zu erzeugen, **dadurch gekennzeichnet,** daß die Oberfläche des Halbleiterbauelementes eine polyederförmige Vertiefung aufweist, deren Seitenwände von Kristallebenen gebildet werden, und daß der darunterliegende, sperrende pn-Übergang dieser Oberflächenkontur folgt.

7. Halbleiterbauelement nach Anspruch 6, **dadurch gekennzeichnet,** daß die Vertiefung die Form eines Pyramidenstumpfes oder einer Pyramide besitzt.

8. Halbleiterbauelement nach Anspruch 6, **dadurch gekennzeichnet,** daß die Oberfläche des Halbleiterbauelementes mehrere Vertiefungen dieser Art aufweist.

9. Halbleiterbauelement nach Anspruch 6, **dadurch gekennzeichnet,** daß der Lawinendurchbruch einen Basisstrom erzeugt, der einen Thyristor durch direkte Ansteuerung des Emitters zündet oder durch Ansteuerung eines Hilfsemitters die Thyristorzündung auslöst.

## Claims

1. Method for defined voltage setting in breakoverproof semiconductor components, in which the surface of the semiconductor component is covered with a mask and a depression is formed under the mask opening by means of an etching step in order to produce a locally defined avalanche breakdown, characterized in that, with a given semiconductor crystal lattice and anisotropic etching, the shape of the mask opening and the orientation thereof along one direction of the crystal are selected in such a way that the depression is polyhedral and its side walls are formed by crystal planes, and in that only after the etching step is doping carried out in the region of the surface provided with the depression.

2. Method according to Claim 1, characterized in that a {100} wafer is used.

3. Method according to Claim 2, characterized in that a rectangular or square etching mask opening is used.

4. Method according to Claim 3, characterized in that the etching mask opening is aligned along the <110> direction of the {100} wafer.

5. Method according to Claim 4, characterized in that either a depression in the shape of a truncated pyramid or a depression in the shape of a pyramid is deliberately produced by selection of the edge length of the etching mask opening and by selection of the etching depth.

6. Semiconductor component having a defined break-over voltage, the surface of the semiconductor component having a depression in order to produce a locally defined avalanche breakdown, characterized in that the surface of the semiconductor component has a polyhedral depression, the side walls of which are formed by crystal planes, and in that the blocking pn junction situated underneath follows this surface contour.

7. Semiconductor component according to Claim 6, characterized in that the depression has the shape of a truncated pyramid or of a pyramid.

8. Semiconductor component according to Claim 6, characterized in that the surface of the semiconductor component has a plurality of depressions of this type.

9. Semiconductor component according to Claim 6, characterized in that the avalanche breakdown generates a base current which triggers a thyristor by direct driving of the emitter or initiates the triggering of the thyristor by driving an auxiliary emitter.

**Revendications**

1. Procédé de réglage d'une manière définie de la tension dans des composants à semiconducteurs supportant les amorçages par recouvrement, dans lequel on recouvre la surface du composant à semiconducteurs d'un masque et on forme un évidement au cours d'une étape d'attaque chimique au-dessous de l'ouverture du masque pour produire un claquage par avalanche défini de manière locale, caractérisé en ce que l'on choisit, pour un réseau cristallin semiconducteur donné et pour une attaque chimique anisotrope, la forme de l'ouverture du masque et son orientation le long d'une direction du cristal de telle sorte que l'évidement soit en forme de polyèdre, dont les faces latérales sont formées de plans du cristal et on n'effectue un dopage dans la zone de la surface, dans laquelle est ménagé l'évidement, qu'après l'étape d'attaque chimique.

2. Procédé suivant la revendication 1, caractérisé en ce que l'on utilise une tranche {100}.

3. Procédé suivant la revendication 2, caractérisé en ce que l'on utilise une ouverture de masque d'attaque chimique rectangulaire ou carrée.

4. Procédé suivant la revendication 3, caractérisé en ce que l'on oriente l'ouverture du masque d'attaque chimique le long de la direction <110> de la tranche {100}.

5. Procédé suivant la revendication 4, caractérisé en ce que l'on produit, en choisissant la longueur du bord de l'ouverture du masque d'attaque chimique et la profondeur d'attaque chimique, de manière ciblée, soit un évidement en forme de tronc de pyramide, soit un évidement en forme de pyramide.

6. Composant à semiconducteurs ayant une tension définie d'amorçage par recouvrement, le composant à semiconducteurs comportant un évidement sur sa surface, pour produire un claquage par avalanche défini de manière locale, caractérisé en ce que la surface du composant à semiconducteurs a un évidement en forme de polyèdre, dont les faces latérales sont formées de plans du cristal et la jonction pn à l'état bloqué se trouvant en-dessous suit ce contour de la surface.

7. Composant à semiconducteurs suivant la revendication 6, caractérisé en ce que l'évidement a la forme d'un tronc de pyramide ou d'une pyramide.

8. Composant à semiconducteurs suivant la revendication 6, caractérisé en ce que la surface du composant à semiconducteurs comporte plusieurs évidements de ce genre.

9. Composant à semiconducteurs suivant la revendication 6, caractérisé en ce que le claquage par avalanche produit un courant de base, qui amorce un thyristor par commande directe de l'émetteur ou qui déclenche l'amorçage du thyristor par commande d'un émetteur auxiliaire.

## FIG 1

## FIG 2

FIG 3

FIG 4

FIG 5